# EUROPÄISCHE PATENTSCHRIFT

(11) **EP 0 535 350 B1**
(45) Veröffentlichungstag und Bekanntmachung des Hinweises auf die Patenterteilung: **08.04.1998**
(21) Anmeldenummer: 92114161.0
(22) Anmeldetag: 19.08.1992
(51) Int. Cl.: H01L 21/331, H01L 21/20

(54) **Verfahren zur Herstellung eines seitlich begrenzten, einkristallinen Gebietes in einem Bipolartransistor**
Process for the manufacture of a side-limited monocrystalline region in a bipolar transistor
Procédé pour la fabrication d'un couche mono-cristalline limitée latéralement dans un transistor bipolaire

(30) Priorität: 23.09.1991 DE 4131619
(43) Veröffentlichungstag der Anmeldung: 07.04.1993
(60) Teilanmeldung: 97114782.2
(73) Patentinhaber: SIEMENS AKTIENGESELLSCHAFT, 80333 München (DE)
(72) Erfinder: Klose, Helmut, Dr., W-8000 München 83 (DE); Meister, Thomas, Dr., W-8025 Taufkirchen (DE); Meul, Hans-Willi, Dr., W-8206 Bruckmühl (DE); Stengl, Reinhard, Dr., W-8901 Stadtbergen (DE)

(56) Entgegenhaltungen:
- EP-A- 0 042 698
- EP-A- 0 430 279
- DE-A- 3 825 701
- US-A- 4 529 455
- US-A- 5 028 557
- INTERNATIONAL ELECTRON DEVICES MEETING 1990, SAN FRANSCO, CA; 9. Dezember 1990, Seiten 607 - 610 F. SATO ET AL
- IEEE TRANSACTIONS ON ELECTRON DEVICES Bd. 37, Nr. 11, November 1990, NEW YORK US Seiten 2336 - 2342 P. J. SCHUBERT ET AL

## Beschreibung

Verfahren zur Herstellung eines seitlich begrenzten, einkristallinen Gebietes auf einem Substrat und dessen Verwendung zur Herstellung eines MOS-Transistors und eines Bipolartransistors

Seitlich begrenzte, einkristalline Gebiete, die durch selektive Epitaxie an der Oberfläche eines Substrats innerhalb begrenzender Strukturen hergestellt werden, finden in der Halbleitertechnologie zunehmend Anwendung. Aus EP 0 418 422 Al ist z. B. ein Bipolartransistor bekannt, dessen Kollektor durch selektive Epitaxie innerhalb eines von Oxidstrukturen begrenzten Bereichs auf der Oberfläche eines Substrats hergestellt wird. Bei der Verwendung eines solchen durch selektive Epitaxie hergestellten, einkristallinen Gebietes als aktiver Teil eines Transistors sind hohe Anforderungen an die Kristallqualität zu stellen.

Bei der selektiven Epitaxie auf einem Substrat aus z. B. Silizium innerhalb einer begrenzenden Struktur aus z. B. Siliziumoxid werden die Abscheidebedingungen für das Silizium so eingestellt, daß das Silizium nur auf Siliziumoberflächen aufwächst. Da das Silizium entsprechend der Orientierung der Oberfläche des Substrats aufwächst, entsteht dabei innerhalb der begrenzenden Struktur ein einkristallines Gebiet. Es wird jedoch beobachtet, daß das einkristalline Gebiet in den der begrenzenden Struktur benachbarten Teilen Kristalldefekte aufweist.

Bei Verwendung eines durch selektive Epitaxie hergestellten einkristallinen Gebietes als aktiven Teil eines Transistors, z. B. als Basis, ist es mit unter wünschenswert, das einkristalline Gebiet seitlich über eine entsprechend dotierte polykristalline Siliziumschicht anzuschließen. Es würde sich daher anbieten, das einkristalline Gebiet innerhalb einer begrenzenden Struktur aus Polysilizium aufzuwachsen. Dabei tritt jedoch das Problem auf, daß das Silizium nicht nur auf der einkristallinen Oberfläche des Substrats sondern auch auf den freiliegenden Oberflächen der polykristallinen Siliziumschicht aufwächst. Da die Oberfläche der polykristallinen Siliziumschicht keine einheitliche Kristallorientierung aufweist, kommt es in dem auf dem Polysilizium aufwachsenden Teil des einkristallinen Gebiets daher zu Korngrenzen in einem solchen Ausmaß, daß diese Teile nicht mehr als einkristallin bezeichnet werden können. Ein solches selektiv aufgewachsenes Siliziumgebiet kann die Anforderungen an die Kristallqualität für ein aktives Teil eines Transistors nicht mehr erfüllen.

Aus International Electron Devices Meeting 1990, San Francisco, CA, IEDM Technical Digest, Seiten 607 bis 610 ist ein Verfahren zur Herstellung eines Bipolartransistors unter Verwendung von selektiver Molekularstrahlepitaxie bekannt. Dabei wird auf einem Substrat aus Silizium durch Trockenätzen ein Emitterfenster in einer Polysiliziumschicht geöffnet, die auf einer dielektrischen Schicht angeordnet ist. Durch selektive Molekularstrahlepitaxie wird auf der freiliegenden Oberfläche des Substrats und auf der überhängenden Polsiliziumschicht selektiv Silizium aufgewachsen. Durch geeignete Bedingungen, die in Tabelle 1 angegeben sind, wird ein selbstjustiertes selektives Aufwachsen bei der Molekularstrahlepitaxie sichergestellt. Bei der Molekularstrahlepitaxie ist auf der Polysiliziumschicht eine dielektrische Schicht angeordnet, deren Flanken teilweise von dielektrischen Flankenbedeckungen bedeckt sind.

Aus US-A-4 529 455 ist bekannt, durch Molekularstrahlepitaxieschichten aus GeₓSi₁₋ₓ auf einem Siliziumsubstrat aufzuwachsen.

Aus US-A-5 028 557 ist ein Verfahren zum gleichzeitigen Herstellen von Bipolar- und Feldeffekttransistoren bekannt. Dabei wird auf ein monokristallines Halbleitersubstrat eine dotierte polykristalline Siliziumschicht aufgebracht. Die Polysiliziumschicht ist vom entgegengesetzten Leitfähigkeitstyp wie das Subsrat dotiert. Anschließend werden Öffnungen in der Polysiliziumschicht mit im wesentlichen senkrechten Flanken gebildet, die die Oberfläche des Substrats in den Bereichen freilegen, in denen ein Emitter oder ein Gate gebildet wird. Durch Tempern der Struktur wird aus der strukturierten Polysiliziumschicht Dotierstoff ausgetrieben und im Substrat dotierte Gebiete für die Basis der Bipolartransistoren bzw. Source/Drain-Gebiete der Feldeffekttransistoren gebildet.

Aus EP-A-O 042 698 ist eine Halbleiteranordnung bekannt, in der dotierte Polysiliziumschichten, die während der Herstellung einer Diffusionsquelle zur Bildung dotierter Gebiete gedient haben, als Elektroden verwendet werden. Insbesondere werden vor der Abscheidung der dotierten Polysiliziumschichten eine SiO₂-Schicht und darüber eine Si₃N₄-Schicht abgeschieden. Die SiO₂-Schicht wird strukturiert, so daß die Oberfläche des Substrats im Bereich des Kontaktes freigelegt wird. Dabei wird die SiO₂-Schicht auch unter die Si₃N₄-Schicht zurückgeätzt. Bei der Abscheidung der dotierten Polysiliziumschicht wird auch an den Flanken der Si₃N₄-Schicht Polysilizium abgeschieden.

Aus IEEE Transactions on Electron Devices, Band 37, Nr. 11, November 1990, Seiten 2336 bis 2342, ist ein Verfahren bekannt, bei dem durch seitliches Unterätzen der Siliziumschicht eines SOI-Substrats das aktive Gebiet eines Bipolartransistors gebildet wird. Die Basis wird in diesem unterätzten Silizium gebildet. Der Kollektor wird über einen durch selektive Epitaxie gebildeten Kollektoranschluß in einem separaten Prozeßschritt hergestellt.

Der Erfindung liegt das Problem zugrunde, ein Verfahren zur Herstellung eines Bipolartransistors anzugeben, der ein seitlich begrenztes, einkristallines Gebiet als aktives Teil umfaßt und der einen tiefreichenden Kollektoranschluß zur Kontaktierung des Kollektors seitlich des einkristallinen Gebietes aufweist.

Dieses Problem wird erfindungsgemäß gelöst durch ein Verfahren nach Anspruch 1. Dabei wächst das einkristalline Gebiet auf der Oberfläche des Substrats auf, die seitlich durch die strukturierte erste Schicht begrenzt wird. Da die erste Schicht eine Unterätzung unter die zweite Schicht aufweist, liegen diejenigen Teile des einkristallinen Gebietes, in denen Kristalldefekte oder Korngrenzen auftreten, unterhalb der Kanten der zweiten Schicht. Innerhalb der strukturierten zweiten Schicht ist das so hergestellte einkristalline Gebiet im wesentlichen frei von Kristalldefekten und genügt den Anforderungen für den Einsatz als aktives Teil eines Transistors.

Es liegt im Rahmen der Erfindung, das einkristalline Gebiet durch Zugabe von Dotierstoff enthaltenden Verbindungen bei der selektiven Epitaxie in-situ zu dotieren. Das hat den Vorteil, daß das einkristalline Gebiet mit einem senkrecht zur Oberfläche des Substrats verlaufenden Dotierstoffprofil herstellbar ist. Es ist insbesondere möglich, daß einkristalline Gebiet an der Oberfläche von einem Leitfähigkeitstyp zu dotieren und darunter eine dünne Schicht vom entgegengesetzten Leitfähigkeitstyp vorzusehen.

Es wird insbesondere ein Substrat aus Silizium verwendet. Das einkristalline Gebiet darauf wird in der Regel aus dem gleichen Halbleitermaterial d. h. ebenfalls aus Silizium erzeugt. Es ist jedoch auch möglich, dem einkristallinen Gebiet ein weiteres Halbleitermaterial beizumischen, z. B. Germanium, so daß das einkristalline Gebiet aus Si₁₋ₓGeₓ wobei x zwischen 0,2 und 0,4 liegt, besteht. Auf diese Weise ist das Verfahren zur Herstellung von Heterobauelementen geeignet.

Es liegt im Rahmen der Erfindung, die erste Schicht aus SiO₂ und die zweite Schicht aus polykristallinem Silizium vorzusehen. In diesem Fall werden die Oberflächen und die Flanken der zweiten Schicht aus polykristallinem Silizium vor der Erzeugung der Unterätzungen mit einer dritten Schicht bedeckt, an deren Oberfläche bei der selektiven Epitaxie keine Keimbildung stattfindet und die den Ätzungen der zweiten Schicht und der ersten Schicht widersteht. Hierzu ist insbesondere Si₃N₄ geeignet. Die dritte Schicht aus Si₃N₄ kann nach der selektiven Epitaxie auf der zweiten Schicht aus polykristallinem Silizium verbleiben. Es ist jedoch vorteilhaft, sie zu entfernen, da dadurch Verspannungen in dem fertigen Bauelement vermieden werden.

Durch Dotierung der zweiten Schicht aus polykristallinem Silizium ist die zweite Schicht als Anschluß für das einkristalline Gebiet verwendbar. Auf diese Weise wird selbstjustiert zu dem einkristallinem Gebiet ein Anschluß gebildet.

Das erfindungsgemäße Verfahren zur Herstellung eines einkristallinen Gebiets ist geeignet, bei der Herstellung eines Bipolartransistors angewendet zu werden. In diesem Fall wird in dem Substrat unterhalb des einkristallinen Gebietes ein Kollektor gebildet. In dem einkristallinen Gebiet wird eine Basis gebildet. Dabei bildet z. B. das einkristalline Gebiet selbst die Basis. Eine andere Möglichkeit besteht darin, daß das einkristalline Gebiet eine Fortsetzung des Kollektors darstellt, in dem die Basis durch Implantation gebildet wird. Oberhalb der Basis wird ein Emitter gebildet, z. B. durch Abscheidung einer entsprechend dotierten polykristallinen Siliziumschicht und anschließende Ausdiffusion. Die zweite Schicht aus polykristallinem Silizium wird so dotiert und strukturiert, daß sie einen Basisanschluß bildet. In diesem Bipolartransistor ist der Basisanschluß selbstjustiert zur Basis angeordnet.

Der Kollektor wird durch einen seitlich von Emitter und Basis angeordneten Kollektoranschluß angeschlossen. Dazu ist es vorteilhaft, nach der Strukturierung des Basisanschlusses und vor der Freilegung der Oberfläche des Substrats ganzflächig und konform eine vierte Schicht abzuscheiden, die dieselben Ätzeigenschaften wie die erste Schicht aufweist. Die vierte Schicht wird planarisiert, so daß die Oberfläche der zweiten Schicht freigelegt wird. Es wird eine Maske erzeugt, die einen ersten Bereich für Emitter, Basis und Kollektor und seitlich davon einen zweiten Bereich für einen Kollektoranschluß definiert. In einem zu Silizium selektiven, anisotropen Ätzschritt wird die Oberfläche der zweiten Schicht im ersten Bereich und die Oberfläche des Substrats im zweiten Bereich freigelegt. Dabei wirkt die zweite Schicht aus polykristallinem Silizium im ersten Bereich und die Oberfläche des Substrats im zweiten Bereich als Ätzstopp. In einem zu SiO₂ selektiven, anisotropen Ätzschritt wird im ersten Bereich die zweite Schicht entfernt und im zweiten Bereich ein Ätzgraben in die Oberfläche des Substrats erzeugt. Die Tiefe des Ätzgrabens wird dabei über die Dauer des Ätzschritts gesteuert. Der erste Bereich und der zweite Bereich werden gleichzeitig unter Verwendung derselben Ätzschritte gebildet. Obwohl im zweiten Bereich für den Kollektoranschluß tiefer in das Substrat hineingeätzt werden muß, wird durch die erfindungsgemäße Schichtfolge ein zusätzlicher Prozeßschritt für die Bildung des zweiten Bereichs vermieden.

Vor der Bildung der Unterätzungen der ersten Schicht werden die freiliegenden Flanken aller an den ersten Bereich und den zweiten Bereich angrenzenden Schichten mit der dritten Schicht aus z. B. Si₃N₄ bedeckt.

Es liegt im Rahmen der Erfindung, nach der selektiven Epitaxie ganzflächig und konform eine Oxidschicht und darauf ganzflächig und konform eine erste polykristalline Silziumschicht abzuscheiden. In einem zu SiO₂ selektiven anisotropen Ätzschritt wird die erste polykristalline Siliziumschicht so zurückgeätzt, daß an den senkrechten Flanken des ersten und des zweiten Bereichs Flankenbedeckungen (Spacer) entstehen. Die freiliegende Oxidschicht wird selektiv zum Silizium naßchemisch entfernt. Die Flankenbedeckungen dienen zur Isolation zwischen der den Basisanschluß bildenden zweiten Schicht und dem anschließend zu erzeugenden Emitteranschluß. Desweiteren wird durch die Flankenbedeckungen der aktive Teil des einkristallinen Gebietes definiert. Etwaige Fehlstellen und Korngrenzen, die an der Kante zur zweiten Schicht bestehen können, liegen damit nicht im aktiven Teil des einkristallinen Gebietes. Durch Erzeugung der Flankenbedeckungen aus zwei Schichten wird eine Belastung der Oberfläche des einkristallinen Gebietes bei dem anisotropen Ätzschritt vermieden.

Nach der Bildung der Flankenbedeckungen und der Freilegung der Siliziumoberfläche im ersten und zweiten Bereich wird ganzflächig und konform eine zweite polykristalline Schicht in einer solchen Dicke erzeugt, daß der erste Bereich und der zweite Bereich davon im wesentlichen aufgefüllt sind. In einem anisotropen Ätzschritt wird die zweite polykristalline Schicht soweit zurückgeätzt, daß die Höhe des im ersten Bereich und im zweiten Bereich verbleibenden Teils der zweiten polykristallinen Schicht im wesentlichen der Höhe des Basisanschlusses entspricht. Die zweite polykristalline Schicht ist so dotiert, daß sie im ersten Bereich als Emitteranschluß und im zweiten Bereich als Kollektoranschluß wirkt. Auf diese Weise ist die Herstellung eines planaren Bipolartransistors möglich.

Im folgenden wird die Erfindung anhand von Ausführungsbeispielen und der Figuren näher erläutert.

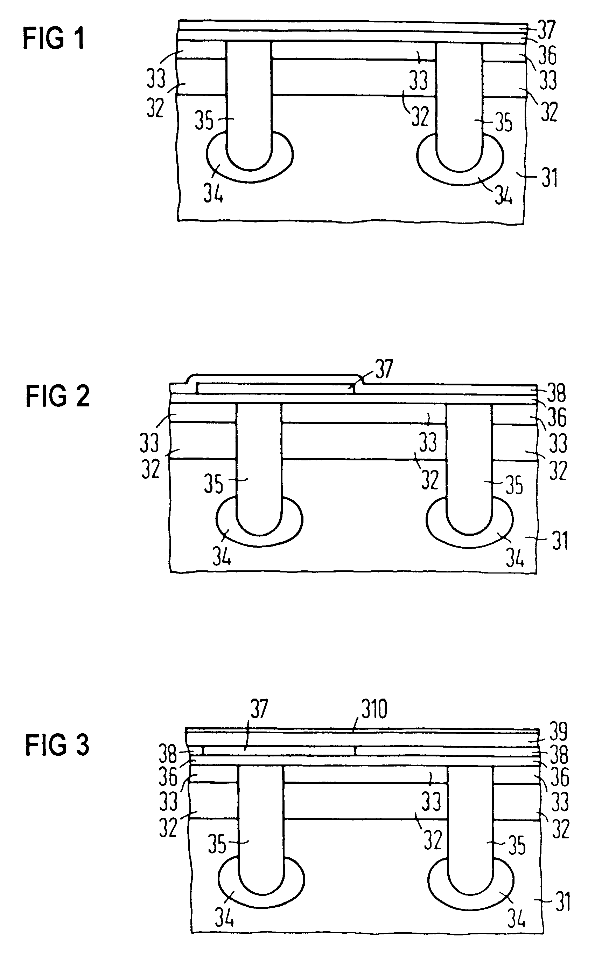

- Fig. 1 bis Fig. 12: zeigt Schritte eines Verfahrens zur Herstellung eines Bipolartransistors.

Auf einem Substrat 31 aus p-dotiertem monokristallinem Silizium wird eine hoch n⁺-dotierte vergrabene Schicht 32 aus einkristallinem Silizium erzeugt. Auf die vergrabene Schicht 32 wird eine niedriger n-dotierte Schicht 33 aus einkristallinem Silizium aufgebracht (s. Fig. 1). In dem Substrat 31 werden Channel-stopper-Bereiche 34 und mit Isolationsmaterial gefüllte Gräben 35 (sogenannte Trenches) nach der in H. Goto, Springer Series in Electronics and Photonics, Bd. 27, S. 61 - 77 beschriebenen Technik gebildet. Die Gräben 35 durchtrennen die n-dotierte Schicht 33 und die vergrabene Schicht 32 und sorgen gemeinsam mit den Channel-stopper-Bereichen 34 für eine sichere seitliche Isolation benachbarter Transistoren im Substrat.

An der Oberfläche der n-dotierten Schicht 33 und der gefüllten Gräben 35 wird als erste Schicht eine Oxidschicht 36 thermisch aufgewachsen. Auf der Oxidschicht 36 wird als zweite Schicht eine polykristalline Siliziumschicht 37 abgeschieden. Die polykristalline Siliziumschicht 37 wird anschließend z. B. mit Bor p-dotiert.

Anschließend wird die polykristalline Siliziumschicht 37 strukturiert (s. Fig. 2). Anschließend erfolgt eine konforme Abscheidung einer SiO₂-Schicht 38. Die SiO₂-Schicht 38 wird mittels eines globalplanarisierenden Verfahrens wie z. B. Rückschleifen oder Rückätzen über Epoxidharz über der Oberfläche der polykristallinen Siliziumschicht 37 entfernt (s. Fig. 3). Die polykristalline Siliziumschicht 37 und die Reste der SiO₂-Schicht 38 bilden dann eine gemeinsame ebene Oberfläche. Darauf wird eine SiO₂-Schicht 39 und darauf eine Si₃N₄-Schicht 310 abgeschieden (s. Fig. 3).

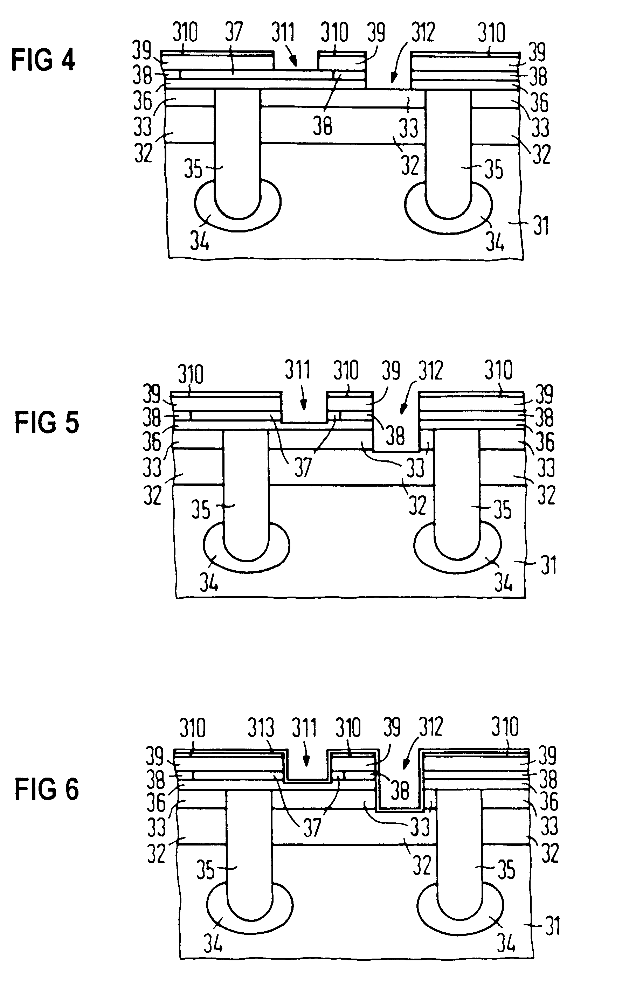

Nach einer Phototechnik (nicht dargestellt) wird die Si₃N₄-Schicht 310 durch anisotropes Ätzen strukturiert. Dabei wird ein erster Bereich 311 und ein zweiter Bereich 312 definiert. Sowohl der erste Bereich 311 als auch der zweite Bereich 312 liegen innerhalb der Gräben 35. Der erste Bereich 311 liegt vollständig oberhalb der polykristallinen Siliziumschicht 37. Der zweite Bereich 312 liegt vollständig seitlich der polykristallinen Siliziumschicht 37. Durch anisotrope Ätzung, die SiO₂ angreift und selektiv zu Silizium ist, wird der erste Bereich 311 in die SiO₂-Schicht 39 und der zweite Bereich 312 in die SiO₂-Schicht 39, die SiO₂-Schicht 38 und die SiO₂-Schicht 36 übertragen. Dabei wird im ersten Bereich die Oberfläche der polykristallinen Siliziumschicht 37 freigelegt. Im zweiten Bereich wird die Oberfläche der n-dotierten Schicht 33, die aus monokristallinem Silizium besteht, freigelegt (s. Fig. 4). Da die Ätzung selektiv zum Silizium erfolgt, wirken die polykristallinen Siliziumschicht 37 und die n-dotierte Siliziumschicht 33 als Ätzstopp.

In einer anisotropen Siliziumätzung wird die polykristalline Siliziumschicht 37 strukturiert. Dabei wirkt die darunterliegende Oxidschicht 36 als Ätzstopp. Im zweiten Bereich 312 wird die n-dotierte Schicht 33 strukturiert. Es entsteht ein Ätzgraben, an dessen Boden die Oberfläche der vergrabenen Schicht 32 freigelegt wird. Die Tiefe des Ätzgrabens wird über die Dauer der anisotropen Siliziumätzung eingestellt (s. Fig. 5).

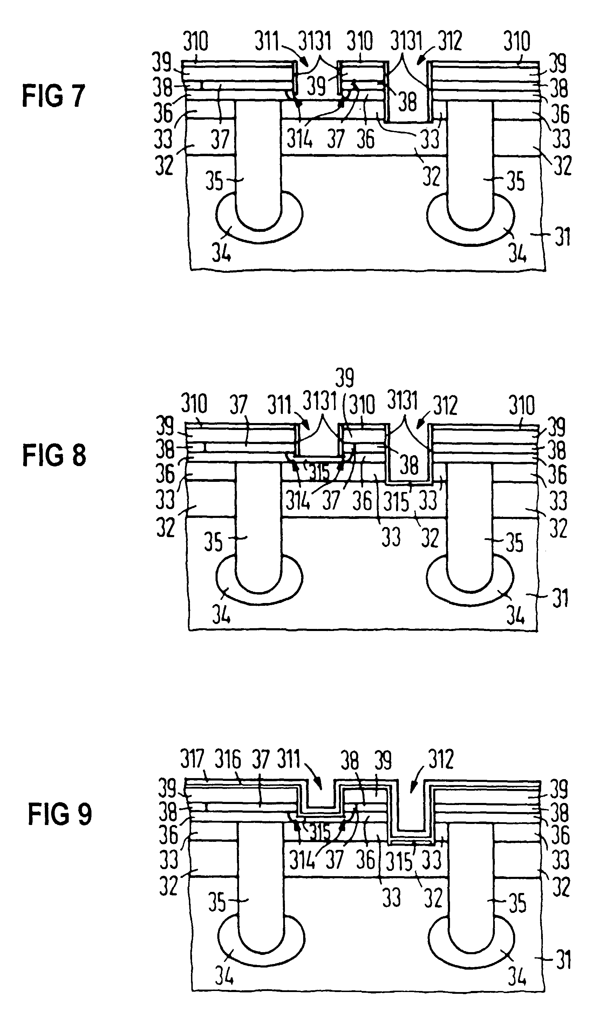

Anschließend wird ganzflächig eine Si₃N₄-Schicht 313 konform abgeschieden (s. Fig. 6). Durch anisotrope Ätzung selektiv zu Silizium und SiO₂ wird die Si₃N₄-Schicht 313 rückgeätzt, so daß daraus Flankenbedeckungen 3131 an den freiliegenden, senkrechten Flanken der Si₃N₄-Schicht 310, der SiO₂-Schicht 39, der polykristallinen Siliziumschicht 37, der Oxidschicht 36 und der n-dotierten Schicht 33 entstehen (s. Fig. 7). In einem isotropen, zu Silizium und Si₃N₄ selektiven, isotropen Ätzschritt wird die Oxidschicht 36 im ersten Bereich 311 entfernt. Dabei wird die Oberfläche der n-dotierten Schicht 33 freigelegt. Gleichzeitig werden Unterätzungen 314 unter die polykristalline Siliziumschicht 37 erzeugt. Die Tiefe der Unterätzungen 314 wird über die Ätzdauer eingestellt. Im zweiten Bereich 312 bewirkt diese Ätzung keinerlei Veränderungen, da sie Silizium und Si₃N₄ nicht angreift (s. Fig. 7).

Mittel selektiver Epitaxie wird an der freiliegenden Oberfläche der n-dotierten Schicht 33 im ersten Bereich 311 und an der freiliegenden Oberfläche der vergrabenen Schicht 32 im zweiten Bereich 312 je ein einkristallines Gebiet 315 erzeugt. Im ersten Bereich wächst das einkristalline Gebiet 315 auch an den freiliegenden Oberflächen der polykristallinen Schicht 37 im Bereich der Unterätzungen 314 auf.

Das einkristalline Gebiet 315 im ersten Bereich 311 bildet eine Basis für einen fertigen Bipolartransistor. Daher wird das einkristalline Gebiet 315 z. B. p-dotiert mit einer Dotierstoffkonzentration von etwa 1 × 10¹⁸ cm³ Bor aufgewachsen. Die Schichtdicke liegt hier im Bereich zwischen 50 und 100 nm. Eine andere Möglichkeit besteht darin, das einkristalline Gebiet 315 Bor/Germanium-dotiert zu realisieren. Dabei liegt der Germaniumanteil im Silizium bei etwa 20 bis 40 Atomprozent. In diesem Fall wird eine Heterostrukturbasis gebildet. Eine weitere Möglichkeit besteht darin, das einkristalline Gebiet 315 niedrig n-dotiert mit einer Dotierstoffkonzentration von etwa 1 × 10¹⁶ cm³ As aufzuwachsen. Das einkristalline Gebiet 315 stellt dann eine Fortsetzung eines von der n-dotierten Schicht 33 gebildeten Kollektors dar. Die Basis wird in diesem Fall durch anschließende, unmaskierte Implantation von Bor eingebracht.

Die Si₃N₄-Schicht 310 und die Flankenbedeckungen 3131, die als Ätzschutz für die darunterliegenden Schichten während der lateral wirkenden isotropen SiO₂-Ätzung dienten (s. Fig. 8), können auf der Struktur verbleiben oder entfernt werden. Die erste Möglichkeit hat den Vorteil der Einsparung von Prozeßschritten, während die zuletzt genannte Möglichkeit den Vorteil hat, daß Verspannungen durch das Si₃N₄ vermieden werden.

Nach dem Entfernen der Si₃N₄-Schicht 310 und der Flankenbedeckung 3131 (s. Fig. 9) wird ganzflächig und konform eine Oxidschicht 316 in einer Dicke von z. B. 50 nm und darauf ganzflächig und konform eine polykristalline Siliziumschicht 317 abgeschieden.

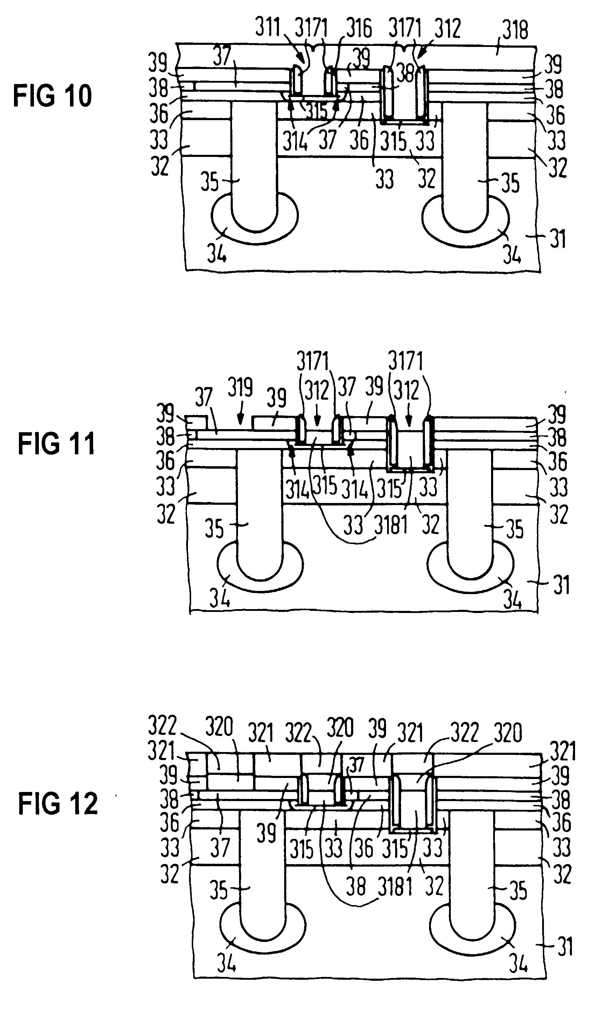

Anschließend wird die polykristalline Siliziumschicht 317 anisotrop selektiv zum Silizumoxid rückgeätzt, wobei Flankenbedeckungen 3171 (Spacer) entstehen (s. Fig. 10). Dabei wirkt die Oxidschicht 316 als Ätzstopp. Die freiliegenden Teile der Oxidschicht 316 werden anschließend naßchemisch selektiv zum Silizium entfernt. Die Herstellung der Flankenbedeckungen 3171 auf diese Weise durch Abscheidung zunächst einer Oxid- und dann einer polykristallinen Siliziumschicht hat gegenüber der Herstellung eines reinen Oxidspacers den Vorteil, daß keine Nachbehandlung zur Entfernung von Polymeren, die bei der Realisierung eines Oxidspacers durch SiO₂-Trockenätzungen auf Siliziumuntergrund entstehen, nötig ist. Damit wird der Siliziumangriff während dieser Polymerentfernung vermieden, der immer an der Oberfläche des einkristallinen Gebietes stattfindet. Dieses führt zu einer deutlichen Erhöhung der Prozeßstabilität. Insbesondere werden Schwankungen in der Dicke des einkristallinen Gebiets 315 vermieden. Dieses ist besonders bei der Herstellung flacher Emitter/Basis-Dotierstoffprofile wichtig, um Schwankungen in der Stromverstärkung des fertigen Bipolartransistors zu unterbinden.

Es folgt eine konforme Abscheidung einer polykristallinen Siliziumschicht 318. Die polykristalline Siliziumschicht 318 wird in einer solchen Dicke abgeschieden, daß sowohl im ersten Bereich 311 als auch im zweiten Bereich 312 der Zwischenraum zwischen den gegenüberliegenden Flankenbedeckungen 3171 jeweils vollständig aufgefüllt wird. Die polykristalline Siliziumschicht 318 wird n⁺-dotiert. Dies erfolgt z. B. durch Arsenimplantation oder durch Arsen dotierte Abscheidung.

Die polykristalline Siliziumschicht 318 wird selektiv zu Siliziumoxid in einem anisotropen Ätzschritt so zurückgeätzt, daß die Höhe der Oberkante des verbleibenden Polysiliziums 3181 im ersten Bereich 311 und im zweiten Bereich 312 in etwa der Höhe der Oberkante der polykristallinen Schicht 37 entspricht (s. Fig. 11). Das verbleibende Polysilizium 3181 im ersten Bereich 311 bildet einen Emitteranschluß, aus dem der Emitter durch Ausdiffusion gebildet wird. Das verbleibende polykristalline Silizium 3181 im zweiten Bereich 312 bildet einen Kollektoranschluß, der über die vergrabene Schicht 32, die als vergrabener Kollektoranschluß wirkt, mit der n-dotierten Schicht 33, die als Kollektor wirkt, verbunden ist. Die polykristalline Schicht 37 bildet den Basisanschluß, der im Bereich der Unterätzungen 314 mit dem die Basis bildenden einkristallinen Gebiet 315 im ersten Bereich 311 verbunden ist. Da Seitenwanddefekte und Facetten des einkristallinen Bereichs 315 im Bereich der Unterätzungen 314 liegen und da durch Ausdiffusion aus dem Basisanschluß 37 in diesem Bereich eine hohe Dotierung erzielt wird, sind diese Kristallfehler für den fertigen Bipolartransistor unschädlich. Nach einer photolithographischen Definition (nicht dargestellt) wird durch anisotropes Ätzen in die SiO₂-Schicht 39 ein Basiskontaktfenster 319 geöffnet, das durch die SiO₂-Schicht 39 hindurch auf die polykristalline Silizumschicht 37, die den Basisanschluß bildet, reicht.

Anschließend werden das Basiskontaktfenster 319, der erste Bereich 311 und der zweite Bereich 312 mit Wolfram aufgefüllt. Dies erfolgt z. B. durch selektive Abscheidung oder konforme Abscheidung mit nachfolgender anisotrope Rückätzung. Dadurch wird eine vollständige Planarität des Bipolartransistors hergestellt (s. Fig. 12). Die Struktur wird anschließend mit einer Passivierungsschicht 321 versehen. In der Passivierungsschicht 321 werden in bekannter Weise Kontaktlöcher geöffnet und mit Metallisierungen 322 zum Anschluß der als Basisanschluß wirkenden polykristallinen Siliziumschicht 37, des als Emitteranschluß wirkenden polykristallinen Siliziums 3181 und des als Kollektoranschluß wirkenden polykristallinen Siliziums 3181 versehen. Als Metallisierung 322 wird ein Aluminium in der für Kontakte üblichen Zusammensetzung z. B. AlSiTi oder AlSiCu gesputtert und strukturiert.

Der sich ergebende Bipolartransistor wird lediglich mit fünf Phototechniken realisiert, wobei die erste Metallisierungsebene mit gerechnet ist. Der Bipolartransistor weist eine Selbstjustierung sowohl bezüglich Emitter/Basis als auch bezüglich Basis/Kollektor auf. Die Fläche, die die Basis-Kollektor-Kapazität definiert, ist identisch mit derjenigen Fläche, die den Stromfluß durch den Kollektor festlegt. Diese Geometrie stellt das Optimum dar, bei dem eine minimale Basis-Kollektor-Kapazität erzielt wird. Der Kollektoranschluß des Bipolartransistors erfolgt über einen Trench-Kontakt, was den Vorteil hat, daß der Anschluß der vergrabenen Schicht 32, die als vergrabener Kollektoranschluß dient, ohne signifikante Temperaturbelastung der Struktur erfolgt. Der Bipolartransistor weist sehr hohe Packungsdichten auf.

Der nach dem erfindungsgemäßen Herstellverfahren realisierte MOS-Transistor hat den Vorteil, selbstjustiert bezüglich Source/Drain und Gate zu sein. Da das Kanalgebiet abgeschieden wird, eröffnen sich die Möglichkeiten von Delta-dotierten Profilen oder Hetero-junction Profilen unter Verwendung von SiGe.

## Patentansprüche

1. Verfahren zur Herstellung eines Bipolartransistors mit folgenden Schritten:
a) in einem Substrat (31) aus einem einkristallinen Halbleitermaterial wird ein Kollektor (33) gebildet,
b) auf dem Substrat (31) wird eine erste Schicht (36) aus SiO₂ erzeugt, die selektiv zu dem Substrat (31) ätzbar ist,
c) auf der ersten Schicht (36) wird eine zweite Schicht (37) aus polykristallinem Silizium erzeugt, zu der die erste Schicht (36) selektiv ätzbar ist,
d) die zweite Schicht (37) wird so dotiert und strukturiert, daß sie einen Basisanschluß bildet,
e) es wird ganzflächig und konform eine vierte Schicht (38) abgeschieden, die dieselben Ätzeigenschaften wie die erste Schicht (36) aufweist,
f) die vierte Schicht (38) wird planarisiert, so daß die Oberfläche der zweiten Schicht (37) freigelegt wird,
g) es wird eine Maske (310) erzeugt, die einen ersten Bereich (311) für Emitter, Basis und Kollektor und seitlich davon einen zweiten Bereich (312) für einen Kollektoranschluß definiert,
h) in einem zu Silizium selektiven, anisotropen Ätzschritt wird die Oberfläche der zweiten Schicht (37) im ersten Bereich (311) und die Oberfläche des Substrats (31) im zweiten Bereich (312) freigelegt,
i) in einem zu Siliziumoxid selektiven, anisotropen Ätzschritt wird im ersten Bereich (311) die zweite Schicht (37) entfernt und im zweiten Bereich (312) ein Ätzgraben in die Oberfläche des Substrats (33) erzeugt, dessen Tiefe über die Dauer des Ätzschritts gesteuert wird,
j) mindestens die Flanken der zweiten Schicht werden mit einer dritten Schicht (310, 3131) bedeckt, an deren Oberfläche bei einer selektiven Epitaxie keine Keimbildung stattfindet und die den Ätzungen der ersten Schicht widersteht,
k) die erste Schicht (36) wird so strukturiert, daß die Oberfläche des Substrats (11, 21, 31) im ersten Bereich freigelegt wird,
l) in einem zum Substrat (31), zur zweiten Schicht (37) und zur dritten Schicht (310, 313) selektiven, isotropen Ätzschritt wird die Oberfläche des Substrats (31) innerhalb einer Unterätzung (314) der ersten Schicht (36) unter die zweite Schicht (37) freigelegt,
m) mittels selektiver Epitaxie wird auf der freiliegenden Oberfläche des Substrats (31) im ersten Bereich (311) ein einkristallines Gebiet (315) erzeugt,
n) in dem einkristallinen Gebiet (315) wird eine Basis gebildet,
o) oberhalb der Basis (315) wird ein Emitter gebildet.

2. Verfahren nach Anspruch 1 mit folgenden Schritten:
a) nach der selektiven Epitaxie wird ganzflächig und konform eine Oxidschicht (316) und darauf ganzflächig und konform eine erste polykristalline Siliziumschicht (317) abgeschieden,
b) in einem zu Siliziumoxid selektivem anisotropen Ätzschritt wird die erste polykristalline Siliziumschicht (317) so zurückgeätzt, daß an den senkrechten Flanken des ersten Bereichs (311) und des zweiten Bereichs (312) Flankenbedeckungen (3171) entstehen,
c) die freiliegende Oxidschicht (316) wird selektiv zum Silizium naßchemisch entfernt.

3. Verfahren nach Anspruch 2 mit folgenden Schritten:
a) nach der Bildung der Flankenbedeckungen (3171) und der Freilegung der Siliziumoberfläche im ersten Bereich (311) und im zweiten Bereich (312) wird ganzflächig und konform eine zweite polykristalline Schicht (318) in einer solchen Dicke erzeugt, daß der erste Bereich (311) und der zweite Bereich (312) davon im wesentlichen aufgefüllt sind,
b) in einem anisotropen Ätzschritt wird die zweite polykristalline Schicht (318) soweit zurückgeätzt, daß die Höhe des im ersten Bereich (311) und im zweiten Bereich (312) verbleibenden Teils der zweiten polykristallinen Schicht (3181) im wesentlichen der Höhe der als Basisanschluß wirkenden zweiten Schicht (37) entspricht.

4. Verfahren nach einem der Ansprüche 1 bis 3,
bei dem das einkristalline Gebiet (314) durch Zugabe von Dotierstoff enthaltenden Verbindungen bei der selektiven Epitaxie in situ dotiert wird.

5. Verfahren nach einem der Ansprüche 1 bis 4,
bei dem ein Substrat (31) aus einkristallinem Silizium verwendet wird.

6. Verfahren nach Anspruch 5,
bei dem das einkristalline Gebiet (314) aus Si₁₋ₓGeₓ mit x zwischen 0,2 und 0,4 gebildet wird.

7. Verfahren nach einem der Ansprüche 1 bis 6,
bei dem die dritte Schicht (310, 3131) nach der selektiven Epitaxie vollständig entfernt wird.

8. Verfahren nach einem der Ansprüche 1 bis 7,
bei dem die dritte Schicht (310, 3131) aus Si₃N₄ und die vierte Schicht (38) aus SiO₂ gebildet werden.

## Claims

1. Method for producing a bipolar transistor, having the following steps:
a) a collector (33) is formed in a substrate (31) made of a monocrystalline semiconductor material,
b) a first layer (36) made of SiO₂ is produced on the substrate (31), which first layer can be etched selectively with respect to the substrate (31),
c) a second layer (37) made of polycrystalline silicon is produced on the first layer (36), the first layer (36) being selectively etchable with respect to the second layer,
d) the second layer (37) is doped and structured to form a base terminal,
e) a fourth layer (38) having the same etching properties as the first layer (36) is deposited conformally over the whole area,
f) the fourth layer (38) is planarized, thereby exposing the surface of the second layer (37),
g) a mask (310) is produced, which defines a first region (311) for emitter, base and collector and, to the side thereof, a second region (312) for a collector terminal,
h) in an anisotropic etching step which is selective with respect to silicon, the surface of the second layer (37) is exposed in the first region (311) and the surface of the substrate (31) is exposed in the second region (312),
i) in an anisotropic etching step which is selective with respect to silicon oxide, the second layer (37) is removed in the first region (311) and an etching trench into the surface of the substrate (33) is produced in the second region (312), the depth of which trench is controlled by way of the duration of the etching step,
j) at least the flanks of the second layer are covered with a third layer (310, 3131), on the surface of which nucleation does not take place during selective epitaxy and which withstands the etchings of the first layer,
k) the first layer (36) is structured in such a way that the surface of the substrate (11, 21, 31) is exposed in the first region,
l) in an isotropic etching step which is selective with respect to the substrate (31), with respect to the second layer (37) and with respect to the third layer (310, 313), the surface of the substrate (31) is exposed within an undercut (314) of the first layer (36) under the second layer (37),
m) by means of selective epitaxy, a monocrystalline region (315) is produced on the exposed surface of the substrate (31) in the first region (311),
n) a base is formed in the monocrystalline region (315),
o) an emitter is formed above the base (315).

2. Method according to Claim 1, having the following steps:
a) after the selective epitaxy, an oxide layer (316) is conformally deposited over the whole area, and a first polycrystalline silicon layer (317) is conformally deposited on the said oxide layer over the whole area,
b) in an anisotropic etching step which is selective with respect to silicon oxide, the first polycrystalline silicon layer (317) is etched back in such a way that flank coverings (3171) are produced on the vertical flanks of the first region (311) and of the second region (312),
c) the exposed oxide layer (316) is removed by wetchemical means selectively with respect to the silicon.

3. Method according to Claim 2, having the following steps:
a) after the formation of the flank coverings (3171) and the exposure of the silicon surface in the first region (311) and the second region (312), a second polycrystalline layer (318) is conformally produced over the whole area with a thickness such that the first region (311) and the second region (312) are essentially filled by it,
b) in an anisotropic etching step, the second polycrystalline layer (318) is etched back until the height reached by that part of the second polycrystalline layer (3181) which remains in the first region (311) and in the second region (312) essentially corresponds to the level of the second layer (37) acting as base terminal.

4. Method according to one of Claims 1 to 3,
in which the monocrystalline region (314) is doped in situ by adding dopant-containing compounds during the selective epitaxy.

5. Method according to one of Claims 1 to 4,
in which a substrate (31) made of monocrystalline silicon is used.

6. Method according to Claim 5,
in which the monocrystalline region (314) is formed from Si₁₋ₓGeₓ, where x is between 0.2 and 0.4.

7. Method according to one of Claims 1 to 6,
in which the third layer (310, 3131) is completely removed after the selective epitaxy.

8. Method according to one of Claims 1 to 7,
in which the third layer (310, 3131) is formed from Si₃N₄ and the fourth layer (38) is formed from SiO₂.

## Revendications

1. Procédé de fabrication d'un transistor bipolaire avec les étapes suivantes :
a) dans un substrat (31), on forme un collecteur (33) à partir d'un matériau semi-conducteur mono-cristallin,
b) sur le substrat (31), on crée une première couche (36) constituée de SiO₂, qui peut être gravée d'une manière sélective par rapport au substrat (31),
c) sur la première couche (36), on crée une deuxième couche (37) constituée de silicium poly-cristallin, par rapport à laquelle la première couche (36) peut être gravée d'une manière sélective,
d) la deuxième couche (37) est dopée et structurée de telle manière qu'elle forme un raccord de base,
e) on dépose sur toute la surface et de manière conforme une quatrième couche (38), qui présente les mêmes caractéristiques de gravure que la première couche (36),
f) la quatrième couche (38) est planarisée, de telle manière que la surface de la deuxième couche (37) est dégagée,
g) on crée un masque (310) qui définit une première région (311) pour l'émetteur, la base et le collecteur et à côté de celui-ci une deuxième région (312) pour un raccord de collecteur,
h) au cours d'une étape de gravure anisotrope, sélective par rapport au silicium, on dégage la surface de la deuxième couche (37) dans la première région (311) et la surface du substrat (31) dans la deuxième région (312),
i) au cours d'une étape de gravure anisotrope, sélective par rapport à l'oxyde de silicium, on enlève dans la première région (311) la deuxième couche (37) et on crée dans la deuxième région (312) une tranchée de gravure dans la surface du substrat (33), dont la profondeur est réglée par la durée de l'étape de gravure,
j) on recouvre au moins les flancs de la deuxième couche avec une troisième couche (310, 3131), à la surface de laquelle ne se produit pas de formation de germes cristallins lors d'une épitaxie sélective et qui résiste aux gravures de la première couche,
k) la première couche (36) est structurée de telle manière qu'on dégage la surface du substrat (11, 21, 31) dans la première région,
I) au cours d'une étape de gravure isotrope, sélective par rapport au substrat (31), par rapport à la deuxième couche (37) et par rapport à la troisième couche (310, 313), on dégage la surface du substrat (31) à l'intérieur d'une sous-gravure (314) de la première couche (36) en dessous de la deuxième couche (37),
m) au moyen d'une épitaxie sélective, on crée sur la surface dégagée du substrat (31) dans la première région (311) une région mono-cristalline (315),
n) dans la région mono-cristalline (315), on forme une base,
o) au-dessus de la base (315), on forme un émetteur.

2. Procédé selon la revendication 1 avec les étapes suivantes :
a) après l'épitaxie sélective, on dépose sur toute la surface et de manière conforme une couche d'oxyde (316) et sur celle-ci, sur toute la surface et de manière conforme, une première couche de silicium poly-cristalline (317),
b) au cours d'une étape de gravure anisotrope, sélective par rapport à l'oxyde de silicium, on regrave la première couche de silicium poly-cristalline (317) de telle manière qu'il se forme des recouvrements de flancs (3171) sur les flancs verticaux de la première région (311) et de la deuxième région (312),
c) on enlève la couche d'oxyde dégagée (316) par un procédé chimique par voie humide de manière sélective par rapport au silicium.

3. Procédé selon la revendication 2 avec les étapes suivantes :
a) après la formation des recouvrements de flancs (3171) et le dégagement de la surface de silicium dans la première région (311) et dans la deuxième région (312), on crée sur toute la surface et de manière conforme une deuxième couche poly-cristalline (318) avec une épaisseur telle que la première région (311) et la deuxième région (312) en sont essentiellement remplies,
b) au cours d'une étape de gravure anisotrope, on regrave la deuxième couche poly-cristalline (318) dans une mesure telle que la hauteur de la partie de la deuxième couche poly-cristalline (3181), subsistant dans la première région (311) et dans la deuxième région (312) correspond essentiellement à la hauteur de la deuxième couche (37) agissant comme raccord de base.

4. Procédé selon l'une des revendications 1 à 3,
dans lequel la région mono-cristalline (314) est dopée par addition de composés contenant un agent de dopage lors de l'épitaxie sélective in situ.

5. Procédé selon l'une des revendication 1 à 4,
dans lequel on utilise un substrat (31) constitué de silicium mono-cristallin.

6. Procédé selon la revendication 5,
dans lequel la région mono-cristalline (314) est formée de Si₁₋ₓGeₓ avec x valant entre 0,2 et 0,4.

7. Procédé selon l'une des revendications 1 à 6,
dans lequel la troisième couche (310, 3131) est complètement enlevée après l'épitaxie sélective.

8. Procédé selon l'une des revendications 1 à 7,
dans lequel la troisième couche (310, 3131) est formée de Si₃N₄ et la quatrième couche (38) est formée de SiO₂.
